# EUROPÄISCHE PATENTSCHRIFT

(11) **EP 1 563 177 B1**
(45) Veröffentlichungstag und Bekanntmachung des Hinweises auf die Patenterteilung: **27.04.2011**
(21) Anmeldenummer: 03809701.0
(22) Anmeldetag: 03.09.2003
(51) Int. Cl.: F02D 41/20

(54) **VERFAHREN ZUM BETRIEB EINES HYDRAULISCHEN EINSPRITZVENTILS MIT EINEM PIEZOELEKTRISCHEN AKTOR SOWIE STEUERGERÄT**
OPERATING METHOD FOR A HYDRAULIC INJECTION VALVE COMPRISING A PIEZOELECTRIC ACTUATOR AND A CONTROL UNIT
PROCEDE POUR FAIRE FONCTIONNER UNE SOUPAPE D'INJECTION HYDRAULIQUE COMPRENANT UN ACTIONNEUR PIEZOELECTRIQUE ET APPAREIL DE COMMANDE

(30) Priorität: 31.10.2002 DE 10250917
(43) Veröffentlichungstag der Anmeldung: 17.08.2005
(73) Patentinhaber: SIEMENS AKTIENGESELLSCHAFT, 80333 München (DE); Gottlieb, Bernhard, 81739 München (DE); Kappel, Andreas, 85649 Brunnthal (DE); Schwebel, Tim, 80337 München (DE)
(72) Erfinder: KAPPEL, Andreas, 85649 Brunnthal (DE); GOTTLIEB, Bernhard, 81739 München (DE); SCHWEBEL, Tim, 80337 München (DE); FISCHER, Bernhard, 84513 Töging A. Inn (DE); BACHMAIER, Georg, 80538 München (DE)
(86) Internationale Anmeldenummer: PCT/DE2003/002931
(87) Internationale Veröffentlichungsnummer: WO 2004/040112

(56) Entgegenhaltungen:
- EP-A- 1 079 158
- DE-A- 3 935 937
- US-A- 5 036 263

## Beschreibung

Die Erfindung geht aus von einem Verfahren zum Betrieb eines hydraulischen Einspritzventils (Injektors), das wenigstens mit einem piezoelektrischen Aktor, mit einem zu bewegenden Bauteil und mit einem hydraulischen Element ausgebildet ist und die in einem gemeinsamen Gehäuse angeordnet sind, wobei durch Anlegen einer Steuerspannung an den Aktor der Hub des zubewegendenBauteils reversibel steuerbar ist, beziehungsweise von einem Steuergerät nach der Gattung der nebengeordneten Ansprüche 1 und 7. Es ist schon bekannt, zur Steuerung einesEinspritzventils,insbesondere für die Kraftstoffeinspritzung in einen Verbrennungsmotor, einen piezoelektrischen Aktor zu verwenden, der mit einer seiner Polungsrichtung entsprechenden Steuerspannung betrieben wird. Dabei nutzt man beispielweise zur direkten Betätigung einer Ventilnadel des Einspritzventils die Längenänderung aus, die der Aktor durch die angelegte Steuerspannung vollzieht. Bei der indirekten Nutzung wird dagegen die Ventilnadel durch Aufstoßen eines Absteuerventils (Servoventils) geöffnet.

Die Längenänderung (Elongation) ist vom physikalischen Prinzip her eine sehr kleine Größe. Um eine nutzbare Längenänderung zu erzielen, wurden beispielsweise vielschichtige Aktoren wie PMA (Piezo-elektrischer Multilayer Aktor) entwickelt und die angelegte Steuerspannung möglichst hoch, zum Beispiel 160V gewählt. Dennoch beträgt die Längenänderung eines solchen Aktors nur 0, 12-0, 14% der Länge des Aktors im entladenen Zustand. Bei höheren Spannungen nimmt der Hub nur noch unterproportional zu. Dagegen werden dann die Feldstärken in den einzelnen Schichten der Piezokeramik, die üblicherweise 80 µm betragen, größer als 2 kV/m. Dieses könnte dann zu neuen Problemen wie elektrischen Spannungsdurchschlägen führen, die den Piezokeramik dann irreversibel schädigen würden.

Prinzipiell ist insbesondere bei direkt betriebenen Hochdruckeinspritzventilen ein großer Hub der Piezokeramik und damit der Ventilnadel erwünscht, da mit einem großen Hub auch eine große Einspritzmenge erzielt werden kann. Dieses wird beispielsweise bei besonders leistungsstarken oder Rennmotoren gefordert.

Bei indirekt betriebenen Einspritzventilen ist ein großer Hub der Ventilnadel insbesondere deswegen erwünscht, weil die Fertigungstoleranzen vergrößert werden können und dadurch Kostenvorteile erzielt werden können.

Zur Vergrößerung des Hubs der Ventilnadel wurde auch schon versucht, die Baulänge des Aktors zu vergrößern. Diese Lösung ist zwar wirkungsvoll, ist aber wegen des oben genannten geringen Elongationsfaktors der Piezokeramik relativ teuer.

Bekannt ist des weiteren, die Einspritzmenge durch einen möglichst langen Spannungsimpuls zu steuern. Die Länge des Einspritzimpulses bei einem Verbrennungsmotor ist aber durch die physikalischen Randbedingungen, insbesondere den optimalen Einspritzzeitpunkt, Abgasforderungen, Temperatur, Laufkultur usw. sehr begrenzt. Insbesondere beider Mehrfacheinspritzung,beiderinnerhalbeines Zyklusses bis zu fünf Injektionen in sehr kurzen Zeitabständen erfolgen, kann nur ein sehr kurzer Einspritzimpuls gewählt werden.

Bei bekannten Einspritzventilen wird häufig auch ein hydraulisches Element (hydraulisches Lager) als Spielausgleichselement verwendet, um parasitäre Spalten zu vermeiden. Dadurch kann der zur Verfügung stehende Hub des Aktors zu nahezu 100% auf die Ventilnadel übertragen werden.

Aus DE 39 35 937 A1 ist eine Vorrichtung zum Ansteuern piezoelektrischer Einspritzeinrichtungen zum Durchführen einer Haupt- und Voreinspritzung in einem Dieselmotor bekannt. Zur Betätigung des piezoelektrischen Elements wird beispielsweise eine Spannung von 800 V auf das piezoelektrische Element aufgebracht. Zum Entladen des piezoelektrischen Elements wird ein Entladethyristor eingeschaltet, wobei die Ansteuerspannung des piezoelektrischen Elements auf einen niedrigen Pegel, wie z. B. - 200 V gebracht wird. In entsprechender Weise werden Vor- und Haupteinspritzung durchgeführt. Auf diese Weise wird eine Stabilisierung der Voreinspritzung und der Haupteinspritzung erreicht.

Der Erfindung liegt die Aufgabe zu Grunde, ein Verfahren zum Betrieb eines hydraulischen Einspritzventils mit einem piezoelektrischen Aktor beziehungsweise ein Steuergerät anzugeben, das große Durchflussmengen bewältigen kann. Diese Aufgabe wird mit den Merkmalen der nebengeordneten Ansprüche 1 und 6 gelöst.

Das erfindungsgemäße Verfahren zum Betrieb eines hydraulischen Einspritzventils beziehungsweise das Einspritzventil mit den kennzeichnenden Merkmalen der nebengeordneten Ansprüche 1 und 6 hat demgegenüber den Vorteil, dass die Elongation des Aktors und damit der Hub des zu bewegenden Bauteils vergrößert werden kann, ohne dass die wirksame elektrische Feldstärke vergrößert werden muss. Durchdie angelegte Biasspannung, die eine Polarität aufweist, die zur Vorpolarisierung des Aktors entgegengesetzt ist, so dass sich der Aktor zuerst verkürzt, wird eine Schädigung des Aktors wirkungsvoll ausgeschlossen. Als besonders vorteilhaft wird dabei angesehen, dass an dem Einspritzventil selbst keine konstruktiven Änderungen vorgenommen werden müssen,so dass das erfindungsgemäße Verfahren generell an handelsübliche Einspritzventile angewendet werden kann. Darüber hinaus wird durch den vergrößerten Hub des zu bewegenden Bauteils in vorteilhafter Weise auch eine größere Einspritzmenge erzielt.

Durch die in den abhängigen Ansprüchen aufgeführten Maßnahmen sind vorteilhafte Weiterbildungen und Verbesserungen des in den nebengeordneten Ansprüche 1 und 6 angeführten Verfahrens beziehungsweise des Einspritzventils gegeben. Als besonders vorteilhaft wird dabei angesehen, dass der Betrag der Biasspannung kleiner ist als der Betrag einer solchen Spannung, die zu einer Umpolung des Aktors führen würde. Denn durch Anlegen der Biasspannung verkürzt sich der Aktor in diesem Spannungsbereich, so dass beim Anlegen der Steuerspannung diese Verkürzung als zusätzliche Elongation des Aktors genutzt werden kann.

Da wegen des hydraulischen Elementes im Einspritzventil die zusätzliche Elongation des Aktors praktisch vollständig auf das zu bewegende Bauteil übertragen wird, ergibt sich in vorteilhafter WeisedessengrößererHub, ohnedassamEinspritzventilmechanische Änderungen vorgenommen werden müssen.

Ein weiterer Vorteil wird auch darin gesehen, dass durch die Biasspannung auch eine Reduzierung des Energieverbrauchs erreicht werdenkann.Durch Verschiebung der Steuerspannungin den teilweise negativen Bereich verringert sich der Energieaufwand, da dieser physikalisch gesehen proportional mit dem Quadrat der Spannung ansteigt.

Eine günstige Lösung wird auch darin gesehen, die Steuerspannung unter Nutzung der Biasspannung zur Einstellung eines definierten Hubs des zu bewegenden Bauteils zu nutzen. Durch den definierten Hub kann auf einfache Weise beispielsweise eine in einen Verbrennungsmotor einzuspritzende Kraftstoffmenge vorteilhaft gesteuert werden, ohne dass die Länge der Einspritzimpulse variiert werden muss. Die Einspritzmenge kann somit auf sehr einfache Weise über die Amplitude der Steuerspannung und/oder der Biasspannung gesteuert werden.

Mit dem Steuergerät kann besondersvorteilhaft ein Einspritzventil gesteuert werden, mit dem Kraftstoff wie Benzin oder Diesel mit hohem Druck in einen Verbrennungsmotor eingespritzt werden soll. Mit dem Aktor lassen sich wegen der geringen Kapazitäten der PMA-Piezokeramik sehr viel kürzere Schaltzeiten erzielen als beispielsweise bei einem Magnetventil, so dass auch bei Mehrfacheinspritzungen sehr große Mengen bei genauer Dosierung des Kraftstoffs möglich sind.

Ein Ausführungsbeispiel der Erfindung ist in der Zeichnung dargestellt und wird in der nachfolgenden Beschreibung näher erläutert.
Figur 1 zeigt ein Diagramm, in dem die Elongation eines piezoelektrischen Aktors in Abhängigkeit von der angelegten Steuerspannung schematisch dargestellt ist,
Figur 2 zeigt zwei Diagramme, wobei die eine Kurve die Elongation des Aktors ohne und eine zweite Kurve die Elongation unter Verwendung einer Biasspannung zeigt,
Figur 3a zeigt zwei Diagramme, in denen der Spannungsverlauf für einen Steuerimpuls über die Zeit aufgetragen ist,
Figur 3b zeigt zwei Diagramme, in denen der Hub der Ventilnadel über die Zeit aufgetragen ist,

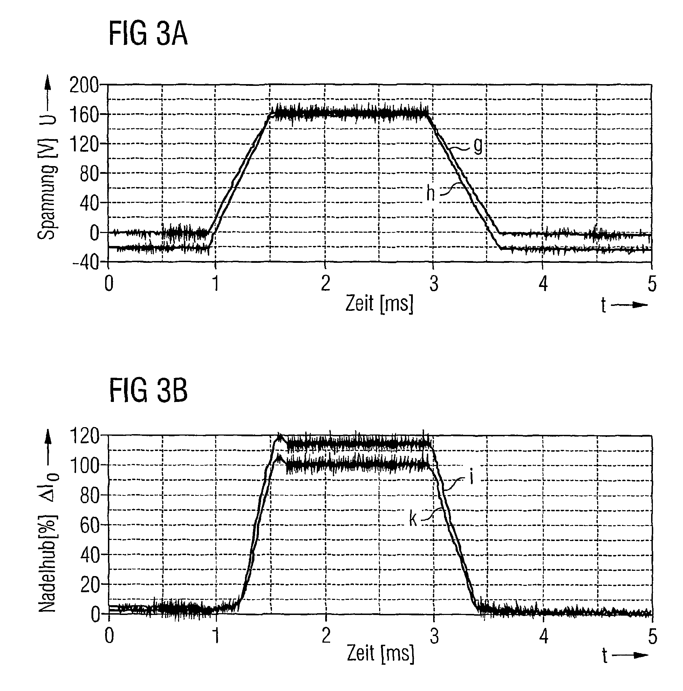

Figur 3a zeigt zwei Diagramme, in denen der Spannungsverlauf für einen Steuerimpuls über die Zeit aufgetragen ist,
Figur 3b zeigt zwei Diagramme, in denen der Hub der Ventilnadel über die Zeit aufgetragen ist,

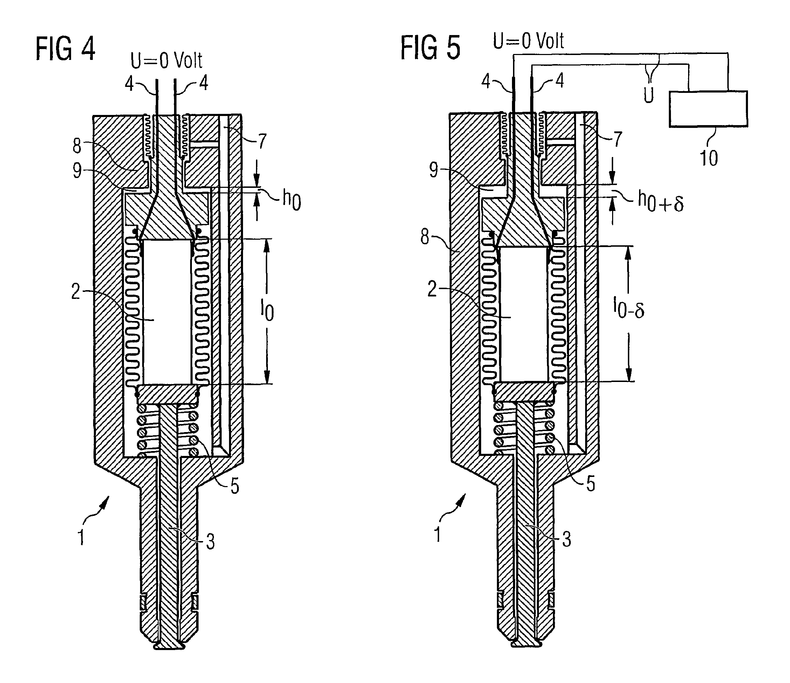

Figur 4 zeigt schematisch ein Einspritzventil ohne Verwendung einer Biasspannung, bei dem das zu bewegende Bauteil (Ventilnadel) geschlossen ist,
Figur 5 zeigt den in Figur 3 dargestellten Fall unter Nutzung einer Biasspannung,

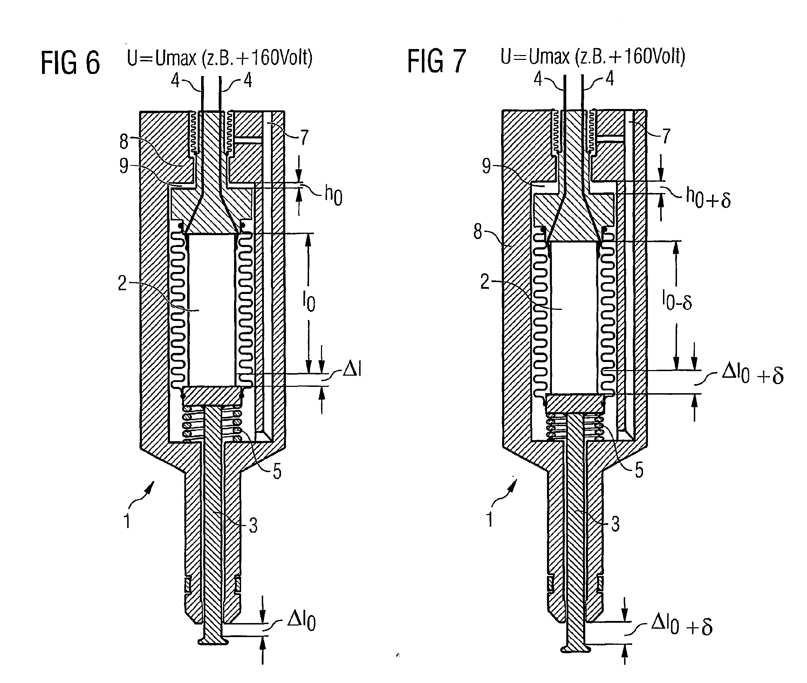

Figur 6 zeigt schematisch ein Einspritzventil ohne Biasspannung aber mit geöffneter Ventilnadel und
Figur 7 zeigt das erfindungsgemäße Einspritzventil mit geöffneter Ventilnadel unter Nutzung einer erfindungsgemäßen Biasspannung.

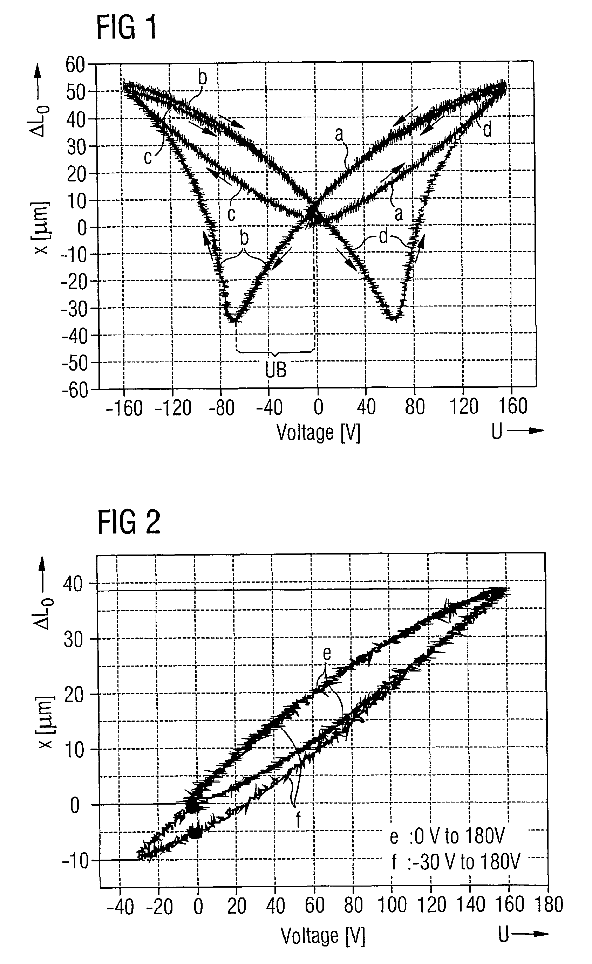

Zum besseren Verständnis der Erfindung wird zunächst an Hand der Diagramme in Figur 1 erläutert, wie sich auf Grund der physikalischen Gegebenheiten die Länge Δl₀ eines Aktors in Abhängigkeit von einer angelegten Steuerspannung U ändert. Die Länge eines PMA-Aktors hängt nicht nur von seinem äußeren elektrischen Feld entsprechend der angelegten Spannung ab, sondern auch von seiner elektrischen Vorgeschichte und seinem Polarisationszustand. Diese beiden Faktoren bestimmen in Verbindung mit dem angelegten äußeren elektrischen Feld die aktuelle Länge des PMA-Aktors. Die Erfindung zeigt nun, wie durch geschicktes Nutzen dieser Zusammenhänge der nutzbare Hub des Aktors vergrößert werden kann.

Als negative Spannung wird eine solche Spannung verstanden, deren Polarität entgegengesetzt ist zur Vorzugspolarisierung des Aktors. Entsprechend wirkt eine positive Spannung in Vorzugsrichtung des Aktors.

Das Diagramm der Figur 1 zeigt insgesamt vier Kurven a bis d, die bei Anlegen einer Spannung an einen beispielsweise 30 mm langen Aktor eine entsprechende Längenänderung oder Hub bewirken. Die Kurve a zeigt den bekannten Normalfall, bei dem entsprechend der Pfeilrichtung die Steuerspannung zunächst vom Wert OV bis auf 160V hochgefahren wird. Der Hub beträgt hier typisch 0...50µm. Wird die Spannung wieder von 160V auf 0V zurückgefahren, ergibt sich der typische obere Hysteresebogen. Der Aktor zieht sich dabei wieder auf seien ursprüngliche Länge zurück, entsprechend 0µm bei 0V. Allerdings geht nach Durchlaufen des Spannungszyklusses der Hub nicht sofort auf 0µm zurück. Auf diesen als langsames ,Kriechen' bekannten Effekt soll hier nicht näher eingegangen werden. Die Kurve a zeigt daher im Bereich des Nullpunktes eine Massierung von Messpunkten an.

Wir nun in einem zweiten Schritt entsprechend der dreieckförmigen Kurve b an den Aktor eine Spannung von 0V...-160V angelegt, dann ergibt sich entsprechend dem unteren Ast der Kurve b ein negativer Hub bis ca. -35µm, also ein Zusammenziehen des Aktors. Die Verkürzung des Aktors geht bis etwa -70V. Bei weiterer negativen Vergrößerung der Steuerspannung U beginnen die einzelnen Domänen des PMA-Aktors sich umzupolen, so dass bis -160V die Länge des Aktors zunimmt und sich wieder ein positiver Hub von ca. 50 µm einstellt (linker aufsteigender Ast der Kurve b). Wird nun die Steuerspannung von -160V auf 0V zurückgefahren, dann geht der Hub auch wieder auf 0 µm zurück.

Bei einem erneuten Durchlaufen des Spannungszyklusses von 0V...-160V und wieder zurück auf 0V ergibt sich die Kurve c, die spiegelbildlich zur Kurve a verläuft.

In einem vierten Schritt wurde entsprechend der Kurve d die Steuerspannung U von 0V bis +160V hochgefahren, wodurch sich zunächst wieder eine weitere Verkürzung um ca. 35 µm bei ca. 70V des Aktors ergab (Kurve d, unterer Ast). Bei höherer Spannung erfolgte wieder eine Umpolarisierung, so dass der Aktor sich wieder ausdehnt. Durch Zurückfahren der Spannung U auf 0V ergibt sich wieder die ursprüngliche Aktorlänge.

Die Erfindung nutzt nun den Bereich, in dem durch Anlegen einer Biasspannung UB der Aktor verkürzt wird. Der Betrag der Biasspannung UB ist dabei kleiner als der Wert der Spannung, die zu einer Umpolarisierung und damit zu einer Verlängerung führt. In unserem Beispiel kann die Biasspannung UB zwischen 0 und bis fast -70V genutzt werden, bei umgedrehter Polarität entsprechend zwischen 0 und bis fast +70V. Erfindungsgemäß wird somit ein Hub von maximal 85 µm erzielt, während der Hub ohne Biasspannung UB nur 50 µm betragen würde. Des weiteren ist vorgesehen, über die Höhe der Biasspannung UB und/oder der Steuerspannung U die Elongation des Aktors und damit einen vorgegebenen Hub des zu bewegenden Bauteils zu steuern. Diese gezielte Steuerung der einzuspritzenden Kraftstoffmenge in einen Verbrennungsmotor ist besonders vorteilhaft.

Dieses angeführte Beispiel ist natürlich abhängig von der gewählten Piezokeramik und dem verwendeten Einsatzbereich, der auch temperaturabhängig sein kann. Aber vom Prinzip her ist eine merkliche Vergrößerung des Hubs durch Anlegen der Biasspannung UB immer möglich.

Die beiden Hysterese-Kennlinien in dem Diagramm der Figur 2 zeigen nun, wie ein PMA-Aktor mit negativer Vorspannung (Biasspannung) betrieben werden kann. Die Kurve e zeigt zunächst einen bekannten Ansteuerzyklus, wie er bereits zur Kurve a in Figur 1 beschrieben wurde. Die Steuerspannung U wird wieder zwischen 0 und 160V gepulst. Der Hub beträgt ca. 38 µm maximal. Die Hysterese-Kennlinie f zeigt nun, wie durch Einsatz einer Biasspannung UB=-30V der Hub auf ca. 48 µm vergrößert werden kann. Der nutzbare Hub konnte somit um 10 µm entsprechend 26% erweitert werden.

Interessant ist in diesem Zusammenhang auch eine Energiebetrachtung für den Aktor. Der Energieverbrauch ist generell E=U²*C/2, wobei C die zu ladende Kapazität des Aktors ist. Wird beispielsweise die Betriebsspannung bei gleichem Hub um nur 20V nach unten verschoben, also von U=0...160V auf U=-20...140V, dann verhalten sich sie beiden Energien wie (20²+140²)/160²=0,78. Der Energiebedarf im verschobenen Bereich ist also um ca. 22% niedriger als wenn keine Biasspannung verwendet wird.

Die Figuren 3a und 3b zeigen Diagramme, wie sie beispielsweise für PMA-Aktoren (Injektoren) verwendet werden können, die zur Benzindirekteinspritzung geeignet sind. In Figur 3a zeigt die obere Kurve g eine Steuerspannung U im Bereich 0...160V, wie sie vom Stand der Technik her bekannt ist. Die untere Kurve h zeigt eine erfindungsgemäße Ansteuerkurve mit einer Biasspannung UB=-20V, so dass die Steuerspannung U einen Zyklus zwischen -20V und +160V durchläuft.

In Figur 3b wurden die entsprechenden Hubkurven für das zu bewegende Bauteil dargestellt. Die untere Kurve k entspricht der Steuerspannung nach Kurve g in Figur 3a. Die obere Kurve i zeigt einen vergrößerten Hub, wie er erfindungsgemäß entsprechend der Kurve h in Figur 3a erwartet wurde. Der Hub ist also in diesem Ausführungsbeispiel um ca. 15% vergrößert worden, wobei die Belastung für den Aktor nur minimal anstieg, da das untere Spannungsniveau auf -20V gelegt wurde. Mit der Erfindung wurde somit ein doppelter Vorteil erzielt: der Hub wurde vergrößert, obgleich die Belastung für den Aktor nahezu konstant blieb.

Zur weiteren Veranschaulichung der Erfindung werden an Hand der Figuren 4 bis 7 die Auswirkungen der Biasspannung UB an einem Einspritzventil 1 (Injektor) erläutert, wie er beispielsweise für die Kraftstoffeinspritzung in einen Verbrennungsmotor Verwendung findet. Bei den dargestellten Einspritzventilen wurde aus Übersichtlichkeitsgründen nur ein einfaches hydraulisches Hochdruckventil dargestellt, das beispielweise für die Benzineinspritzung verwendet werden kann. Die Darstellungen sind nicht maßstabsgetreu, sondern wurden teilweise vergrößert dargestellt, da sich sie Längenänderungen des Aktors in der Praxis nur im µm-Bereich bewegen.

Figur 4 zeigt zunächst das per se bekannte Einspritzventil 1 mit einem Aktor 2, einem hydraulischen Element 9 und einem zu bewegenden Bauteil 3, die in einem gemeinsamen Gehäuse 8 angeordnet sind. Das zu bewegende Bauteil 3 ist in diesem Fall als Ventilnadel ausgebildet, die sich bei Elongation des Aktors 3 nach unten öffnet. Im Ruhezustand, d.h. ohne Steuerspannung U wird der Ventilkopf durch eine Rückstellfeder 5 gegen eine Auslassöffnung gepresst, so dass diese geschlossen wird. Der Aktor 2 ist des weiteren mit dem Schaft der Ventilnadel 3 fest verbunden. Sein oberes Ende steht mit einem hydraulischen Element 9 in Verbindung, das über eine Leckspalte von einer Kraftstoff-Hochdruckleitung 7 befüllt werden kann. Das hydraulische Element 9 wirkt hier als hydraulisches Lager, das gegenüber der Entladungszeit des Aktors 2, die 1 bis 5 ms betragen kann; eine sehr lange Zeitkonstante aufweist. Gegenüber dem Gehäuse 8 sind die beweglichen Teile mit einem Balg entsprechend abgedichtet. Die Spannungsversorgung für den Aktor 2 erfolgt über Leitungen 4. Die gepulste Steuerspannung U wird dabei von 0V auf einen gewünschten Wert, zum Beispiel +160V geschaltet und nach Ablauf einer vorgegebenen Pulsdauer wieder auf 0V zurückgeschaltet (vgl. Figur 3a).

Bei dem bekannten Einspritzventil 1 hat das hydraulische Lager 9 einen Flüssigkeitspegel h₀, der sich über die Leckspalte langsam ändern kann. Der Aktor 2 weist im Ruhezustand die Länge l₀ auf. Beim Anlegen der Steuerspannung U=160V öffnet sich die Ventilnadel 3 entsprechend der Kurve k (vgl. Figur 3b).

Alternativ ist jedoch auch vorgesehen, durch konstruktive Umgestaltung des Injektors 1 die Ventilnadel 3 nach innen zu öffnen. Auch kann insbesondere für die Dieseleinspritzung, bei der noch höhere Drücke erzeugt werden, der Injektor 3 mit einem Servoventil ausgebildet sein, wobei das Servoventil auf ein hydraulisches Element wirkt, das dann als hydraulischer Übertrager ausgebildet ist.

Die verschiedenen Typen von Einspritzventilen sind per se bekannt, so dass deren Funktion nicht näher erläutert werden muss.

An Hand der Figur 5 wird nun die Wirkungsweise der Erfindung erläutert, wenn sie bei einem Einspritzventil 1 gemäß der Figur 4 angewendet wird. Die Bezeichnungen sind wieder die gleichen, wie sie in Figur 4 beschrieben wurden. Jetzt wird jedoch an den Aktor 2 mit Hilfe eines Steuergerätes 10 eine Biasspannung UB angelegt, die eine der Polungsrichtung des Aktors 2 entgegengesetzte Polarität aufweist. In diesem Beispiel sei die Vorzugspolarisierung in der Piezokeramik positiv gerichtet, so dass die Biasspannung UB<0V ist, beispielsweise -30V. Als Folge dessen verkürzt sich der Aktor 2 auf die Länge l₀-δ. Das hydraulische Lager 9 füllt sich langsam um die Längendifferenz δ, bis das hydraulische Lager 9 die Höhe h₀+δ einnimmt. In diesem Zustand verharrt der Aktor 2, bis das Steuergerät 10 eine positive Steuerspannung U erzeugt, die eine entsprechende Elongation des Aktors 2 bewirkt.

Die beiden Figuren 6 und 7 zeigen im Vergleich die Wirkungsweise bei der bekannten Ansteuerung (Figur 6) und der erfindungsgemäßen Ansteuerung (Figur 7).

Entsprechend der Figur 6 ändert sich nun beim Anlegen der Steuerspannung U=160V die Länge l₀ des Aktors 2 um den Hub Δl₀. In der Realität beträgt der Hub Δl₀ nur ca. 0,13% der Länge l₀ und ist hier stark vergrößert dargestellt worden. Das hydraulische Lager 9 behält im wesentlichen seine Höhe h₀ bei. Die kleinen Verluste durch Spaltströmung fallen wegen der kurzen Betriebszeit von typisch 1...5 ms praktisch nicht ins Gewicht. Wegen der festen Verbindung mit der Ventilnadel 3 wird das Ventil ebenfalls um den Hub Al₀ geöffnet.

Figur 7 zeigt nun das erfindungsgemäße Verfahren, bei dem eine Biasspannung UB an das Einspritzventil 1 angelegt wurde, die den Aktor 2 verkürzt hat. Dieser Fall wurde zuvor zu Figur 5 erläutert. Wird nun - ausgehend von der negativen Biasspannung UB - vom Steuergerät 10 ebenfalls die Steuerspannung U=160V angelegt, dann ändert sich die Länge des Aktors 2 auf den Wert Al₀+δ. Damit wird auch der Hub der Ventilnadel 3 auf den Wert Al₀+δ erhöht und erreicht gegenüber dem bekannten Verfahren eine deutliche Vergrößerung. Die Höhenänderung δ des hydraulischen Lagers 9 wird fast vollständig auf den Nadelhub übertragen, wenn man Effekte zweiter Ordnung, beispielsweise die leicht veränderte Steifigkeit des hydraulischen Lagers als Folge der Höhenänderung vernachlässigt. Auf jeden Fall ist der erfindungsgemäße Nadelhub Al₀+δ immer größer als beim Stand der Technik.

Figur 7 zeigt eine idealisierte Momentaufnahme für den Zustand unmittelbar nach dem Öffnen des Injektors 2. Auf Dauer entleert sich das hydraulische Lager 9 und driftet langsam zurück. Daher sollte die Festlegung der Zeitkonstanten an die realen Gegebenheiten möglichst exakt angepasst werden. Für das erfindungsgemäße Verfahren hat diese Abstimmung jedoch keine grundsätzliche Bedeutung.

## Patentansprüche

1. Verfahren zum Betrieb eines Einspritzventils, das wenigstens folgende in einem gemeinsamen Gehäuse (8) angeordnete Bauteile aufweist:
- einen piezoelektrischen Aktor (2) zur Erzeugung eines Hubs,
- ein zu bewegendes Bauteil (3), insbesondere eine Düsennadel, und
- ein hydraulisches Element (9) zum Spielausgleich,
wobei der Aktor (2) mit einer Biasspannung (UB) angesteuert wird, die eine Polarität aufweist, die zur Vorzugspolarisierung des Aktors (2) entgegengesetzt ist, so dass sich der Aktor zuerst verkürzt, und
wobei durch Anlegen einer Steuerspannung (U) an den Aktor (2), die die gleiche Polarität wie die Vorzugspolarisierung des Aktors aufweist, ein Hub am zu bewegenden Bauteil (3) erzeugbar ist, der um die anfängliche Verkürzung überhöht ist.

2. Verfahren nach Anspruch 1, **dadurch gekennzeichnet, dass** der Betrag der Biasspannung (UB) kleiner ist als der Betrag einer solchen Spannung, die zu einer Umpolung des Aktors (2) führen würde.

3. Verfahren nach einem der vorhergehenden Ansprüche, **dadurch gekennzeichnet, dass** die Biasspannung (UB) derart bestimmt wird, dass eine Reduzierung des Energieverbrauchs für den Aktor (2) eintritt.

4. Verfahren nach einem der vorhergehenden Ansprüche, **dadurch gekennzeichnet, dass** die Steuerspannung (U) unter Nutzung der Biasspannung (UB) zur Einstellung eines definierten Hubs (Δl₀+δ) des zu bewegenden Bauteils (3) vorgegeben wird.

5. Verfahren nach Anspruch 4, **dadurch gekennzeichnet, dass** mit dem definierten Hub (Δl₀+δ) des zu bewegenden Bauteils (3) die Einspritzmenge bestimmt wird.

6. Einspritzventil (1) mit einem bewegenden Bauteil (3) und einem hydraulischen Element (9) zum Spielausgleich und einem Steuergerät (10) zur Erzeugung einer Steuerspannung (U) und/oder einer Biasspannung (UB) für einen piezoelektrischen Aktor (2) eines Einspritzventils (1), / welches ein zu bewegendes Bauteil (3) und ein hydraulisches Element (9) aufweist, wobei die Bauteile in einem gemeinsamen Gehäuse (8) angeordnet sind und
wobei das Steuergerät (10) eine Biasspannung (UB) erzeugt, die in der Polungsrichtung des Aktors (2) entgegengesetzt ist, mit welcher der Aktor (2) angesteuert wird, so dass sich der Aktor zuerst verkürzt und
wobei das Steuergerät eine Steuerspannung (U) erzeugt, die die gleiche Polarität wie die Vorzugspolarisierung des Aktors aufweist, mit der der Aktor (2) zur Erzeugung eines Hubs des zu bewegenden Bauteils (3) angesteuert wird und eine Hubvergrößerung durch die anfängliche Aktorverkürzung darstellbar ist.

7. Einspritzventil nach Anspruch 6, **dadurch gekennzeichnet, dass** der Betrag der Biasspannung (UB) kleiner ist als der Betrag einer solchen Spannung, die zu einer Umpolung des Aktors (2) führen würde.

8. Einspritzventil nach einem der Ansprüche 6 oder 7, **gekennzeichnet durch** eine Verwendung für die Kraftstoffeinspritzung in einen Benzinmotor.

9. Einspritzventil nach einem der Ansprüche 6 oder 7, **gekennzeichnet durch** eine Verwendung für die Kraftstoffeinspritzung in einen Dieselmotor.

## Claims

1. Method for operating an injection valve having at least the following components disposed in a common housing (8):
- a piezoelectric actuator (2) for generating a stroke,
- a displaceable component (3), in particular a nozzle needle, and
- a hydraulic element (9) for compensating play,
wherein the actuator (2) is driven by means of a bias voltage (UB) that has an opposite polarity to the preferred polarisation of the actuator (2) such that the actuator initially contracts, and
wherein a stroke that is increased in length by the initial contraction can be generated on the displaceable component (3) by applying to the actuator (2) a control voltage (U) that has the same polarity as the preferred polarisation of the actuator.

2. Method according to claim 1, **characterised in that** the absolute value of the bias voltage (UB) is less than the value of a voltage that would lead to a reversal of the polarity of the actuator (2).

3. Method according to one of the preceding claims, **characterised in that** the bias voltage (UB) is determined in such a way that a reduction in energy consumption occurs for the actuator (2).

4. Method according to one of the preceding claims, **characterised in that** the control voltage (U) is specified using the bias voltage (UB) for the purpose of setting a defined stroke (Δl₀+δ) of the displaceable component (3).

5. Method according to claim 4, **characterised in that** the injection volume is determined by means of the defined stroke (Δl₀+δ) of the displaceable component (3).

6. Injection valve (1) comprising a moving component (3) and a hydraulic element (9) for compensating play and a control unit (10) for generating a control voltage (U) and/or a bias voltage (UB) for a piezoelectric actuator (2) of an injection valve (1) which has a displaceable component (3) and a hydraulic element (9),
wherein the components are disposed in a common housing (8) and
wherein the control unit (10) generates a bias voltage (UB) which is opposite to the polarisation direction of the actuator (2) and by means of which the actuator (2) is driven such that the actuator initially contracts and
wherein the control unit generates a control voltage (U) which has the same polarity as the preferred polarisation of the actuator and by means of which the actuator (2) is driven in order to generate a stroke of the displaceable component (3) and an increase in stroke length can be represented by the initial contraction of the actuator.

7. Injection valve according to claim 6, **characterised in that** the absolute value of the bias voltage (UB) is less than the value of a voltage that would lead to a reversal of the polarity of the actuator (2).

8. Injection valve according to one of claims 6 or 7, **characterised by** use for injecting fuel into a petrol engine.

9. Injection valve according to one of claims 6 or 7, **characterised by** use for injecting fuel into a diesel engine.

## Revendications

1. Procédé pour faire fonctionner une soupape d'injection qui comprend au moins les éléments suivants disposés dans un boîtier commun (8) :
- un actionneur piézoélectrique (2) pour produire une course,
- un élément à déplacer (3), notamment une aiguille d'injecteur, et
- un élément hydraulique (9) pour la compensation de jeu,
l'actionneur (2) étant commandé par une tension de polarisation (UB) dont la polarité est opposée à la polarisation préférentielle de l'actionneur (2), de manière à ce que l'actionneur se raccourcisse d'abord et,
une course qui est augmentée du raccourcissement de départ pouvant être produite au niveau de l'élément à déplacer (3) en appliquant à l'actionneur (2) une tension de commande (U) de même polarité que la polarisation préférentielle de l'actionneur.

2. Procédé selon la revendication 1, **caractérisé en ce que** la valeur absolue de la tension de polarisation (UB) est inférieure à la valeur absolue d'une tension qui entraînerait une inversion de polarité de l'actionneur (2).

3. Procédé selon l'une des revendications précédentes, **caractérisé en ce que** la tension de polarisation (UB) est déterminée de manière à obtenir une réduction de la consommation d'énergie pour l'actionneur (2).

4. Procédé selon l'une des revendications précédentes, **caractérisé en ce que** la tension de commande (U) est prédéfinie en utilisant la tension de polarisation (UB) pour le réglage d'une course définie (Δl₀+δ) de l'élément à déplacer (3).

5. Procédé selon la revendication 4, **caractérisé en ce que** la quantité d'injection est déterminée avec la course définie (Δl₀+δ) de l'élément à déplacer (3).

6. Soupape d'injection (1) comprenant un élément à déplacer (3) et un élément hydraulique (9) pour la compensation de jeu et un appareil de commande (10) pour produire une tension de commande (U) et/ou une tension de polarisation (UB) pour un actionneur piézoélectrique (2) d'une soupape d'injection (1) qui comprend un élément à déplacer (3) et un élément hydraulique (9), les éléments étant disposés dans un boîtier commun (8) et,
l'appareil de commande (10) produisant une tension de polarisation (UB) opposée à la direction de polarité de l'actionneur (2), avec laquelle l'actionneur (2) est commandé de manière à ce que l'actionneur se raccourcisse d'abord et
l'appareil de commande produisant une tension de commande (U) de même polarité que la polarisation préférentielle de l'actionneur, avec laquelle l'actionneur (2) est commandé pour produire une course de l'élément à déplacer (3) et un allongement de la course rendu possible par le raccourcissement de départ de l'actionneur pouvant être obtenu.

7. Soupape d'injection selon la revendication 6, **caractérisée en ce que** la valeur absolue de la tension de polarisation (UB) est inférieure à la valeur absolue d'une tension qui entraînerait une inversion de polarité de l'actionneur (2).

8. Soupape d'injection selon l'une des revendications 6 ou 7, **caractérisée par** une utilisation pour l'injection de carburant dans un moteur à essence.

9. Soupape d'injection selon l'une des revendications 6 ou 7, **caractérisée par** une utilisation pour l'injection de carburant dans un moteur diesel.
